(19) Europäisches Patentamt
European Patent Office
Office européen des brevets

(11) **EP 3 015 565 A1**

(12) **EUROPEAN PATENT APPLICATION**
published in accordance with Art. 153(4) EPC

(43) Date of publication:
**04.05.2016 Bulletin 2016/18**

(51) Int Cl.:
**C23C 14/34** (2006.01)        **C04B 35/44** (2006.01)

(21) Application number: **14818106.8**

(22) Date of filing: **02.06.2014**

(86) International application number:
**PCT/JP2014/064593**

(87) International publication number:
**WO 2014/208282 (31.12.2014 Gazette 2014/53)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **26.06.2013   JP 2013134006
24.12.2013   JP 2013265587**

(71) Applicant: **Asahi Glass Company, Limited
Tokyo 100-8405 (JP)**

(72) Inventors:
• **ITO, Kazuhiro**
  **Tokyo 100-8405 (JP)**
• **WATANABE, Satoru**
  **Tokyo 100-8405 (JP)**
• **MIYAKAWA, Naomichi**
  **Tokyo 100-8405 (JP)**
• **WATANABE, Toshinari**
  **Tokyo 100-8405 (JP)**
• **MITSUI, Akira**
  **Tokyo 100-8405 (JP)**

(74) Representative: **Müller-Boré & Partner
Patentanwälte PartG mbB
Friedenheimer Brücke 21
80639 München (DE)**

(54) **SPUTTERING TARGET, AND METHOD FOR MANUFACTURING THIN FILM USING SAID TARGET**

(57)    A sputtering target for forming an amorphous film includes an electrically conductive mayenite compound. Electron density of the electrically conductive mayenite compound is greater than or equal to $3 \times 10^{20} cm^{-3}$, and the electrically conductive mayenite compound includes one or more elements that are selected from a group including C, Fe, Na, and Zr.

EP 3 015 565 A1

**Description**

TECHNICAL FIELD

The present invention relates to a sputtering target, and especially to a sputtering target that is suitable for forming a thin film of an electride of an amorphous oxide including a calcium atom and an aluminum atom, and to a method of producing a thin film by using the target.

BACKGROUND ART

A mayenite compound has a representative composition that is expressed by $12CaO \cdot 7Al_2O_3$, and the mayenite compound has a characteristic crystal structure including three-dimensionally connected gaps (cages), each of which has a diameter of approximately 0.4 nm. A framework that forms the cage is positively charged, and twelve cages are formed per unit lattice. Inner parts of one-sixth of the cages are filled with oxygen ions, so that an electrically neutral condition of a crystal is satisfied. However, the oxygen ions in the cages have a property that is chemically different from that of other oxygen ions forming the framework. For this reason, the oxygen ions in the cages are particularly called free oxygen ions. The mayenite compound is also denoted as $[Ca_{24}Al_{28}O_{64}]^{4+} \cdot 2O^{2-}$ (Non-Patent Document 1).
If a part of or all the free oxygen ions in the cages of the mayenite compound are replaced with electrons, electrical conductivity is added to the mayenite compound. That is because electrons that are included in the cages of the mayenite compound are not really restricted by the cages, and the electrons can freely move within the crystal (Patent Document 1). Such a mayenite compound having electric conductivity is particularly called "an electrically conductive mayenite compound."
It is expected that such an electrically conductive mayenite compound is applied to a cold electron emission source and an electron injection electrode for an organic EL element, or a reducing agent that utilizes chemical reaction, etc., because such an electrically conductive mayenite compound has an extremely small work function, which is approximately 2.4 eV.

PRIOR ART DOCUMENTS

PATENT DOCUMENTS

Patent Document 1: WO 2005/000741

NON-PATENT DOCUMENTS

Non-Patent Document 1: F. M. Lea, C. H. Desch, The Chemistry of Cement and Concrete, 2nd ed., p.52, Edward Arnold & Co., London, 1956

SUMMARY OF THE INVENTION

PROBLEM TO BE SOLVED BY THE INVENTION

In general, a bulk body of an electrically conductive mayenite compound is produced by applying a sintering process to a powder of an electrically conductive mayenite compound under a high temperature reducing atmosphere (Patent Document 1). The temperature of the sintering process is, for example, approximately 1200 °C.
However, though such a usual method is effective as a method of producing a bulk body of an electrically conductive mayenite compound, the method may not be suitable as a method of producing a thin film shaped electrically conductive mayenite compound.
Namely, if an attempt is made to produce a thin film of an electrically conductive mayenite compound by the usual method in which a high temperature may be required, such as a temperature that is greater than or equal to 1200 °C, only very limited types of heat resistant materials can be a material for a supporting substrate of the thin film. As a consequence, a problem may arise that types of combinations between the thin film and the substrate may be significantly limited.
For example, a glass substrate can often be used for various types of electrical devices or elements as a versatile substrate. However, a maximum heat resistant temperature of a versatile glass substrate may be approximately 700 °C. Thus, with the usual method, it may be difficult to form a thin film of an electrically conductive mayenite compound on the glass substrate because of the relationship with the heat resistant temperature of the glass substrate.
Accordingly, there is a great desire for a technique of producing a thin film of a conductive mayenite compound under a low processing temperature so as to avoid or suppress such a problem.

The inventors of the present invention have found that a thin film of an electride of an amorphous oxide including a calcium atom and an aluminum atom can be formed by forming a film by a vapor deposition method under a low oxygen partial pressure atmosphere by using an electrically conductive mayenite compound as a target.

An object of the present invention is to provide a novel electrically conductive mayenite compound as a sputtering target, with which a thin film of an electride of an amorphous oxide including a calcium atom and an aluminum atom can be formed by the sputtering method.

MEANS FOR SOLVING THE PROBLEM

According to the present invention, there is provided a sputtering target for forming an amorphous film, wherein the sputtering target includes an electrically conductive mayenite compound, wherein electron density of the electrically conductive mayenite compound is greater than or equal to $3 \times 10^{20}$ cm$^{-3}$, and wherein the electrically conductive mayenite compound includes one or more elements that are selected from a group including carbon (C), iron (Fe), sodium (Na), and zirconium (Zr).

Additionally, according to the present invention, there is provided a method of producing a thin film of an electride of an amorphous oxide including a calcium atom and an aluminum atom, wherein the thin film of the electride of the amorphous oxide including the calcium atom and the aluminum atom (which may also be referred to as "an amorphous electride thin film," hereinafter) is formed by forming a film on a substrate by a sputtering method under a low oxygen partial pressure atmosphere by using the above-described sputtering target.

The inventers have confirmed that, by forming an electron injection layer of an organic electroluminescence element by an amorphous electride thin film, an electric voltage-electric current density characteristic of the organic electroluminescence element can be enhanced compared to a case where the electron injection layer is formed by a film of lithium fluoride.

It can be considered that, for the film of lithium fluoride, metallic lithium can be separated in the film, and electrons are emitted from the metallic lithium. Namely, for the film of lithium fluoride, electrons may be emitted from a "point," which is a portion at which the metallic lithium is separated on the surface of the film.

Whereas, in the thin film of the above-described electride of amorphous oxide, electrons can be emitted from the entire surface of the film, namely, electrons can be emitted from a "surface." It can be considered that, for this reason, the electric current density can be enlarged compared to the film of lithium fluoride.

The electric current density of the organic electroluminescence element can further be enlarged, if the electrically conductive mayenite compound that is included in the sputtering target includes one or more elements that can be selected from a group that is formed of C, Fe, Na, and Zr.

For a case where the electrically conductive mayenite compound forming the sputtering target includes one or more elements that are selected from a group that is formed of C, Fe, and Zr, the one or more elements may exist in the formed thin film of the amorphous electride. It can be considered that the thin film of the amorphous electride that includes the one or more elements can increase a ratio of fine crystals that exist in the film. It can be considered that, as the ratio of the fine crystals increases, direct current electrical conductivity of the film can be increased, and thereby the electric current density of the film can be increased.

The conductive mayenite compound forming the sputtering target may more preferably include C or Fe.

Whereas, if the electrically conductive mayenite compound forming the sputtering target includes Na, it follows that the element exists in the thin film of the formed amorphous electride. The thin film of the amorphous electride including the element tends to cause interface reaction at the interface contacting another layer. It can be considered that, when a reaction layer is formed by interface reaction, a Schottky barrier can be lowered, and the electric current density of the film can be increased. Namely, it can be considered that, in the organic electroluminescence element, if an electron injection layer is formed of a thin film of an electride of an amorphous oxide including Na, a Schottky barrier between the electron injection layer and an electron transport layer is lowered, and it becomes easy for an electric current to flow.

ADVANTAGEOUS EFFECT OF THE INVENTION

According to the present invention, a novel sputtering target can be provided with which a thin film of an electride of an amorphous oxide including a calcium atom and an aluminum atom can be formed.

BRIEF DESCRIPTION OF THE DRAWINGS

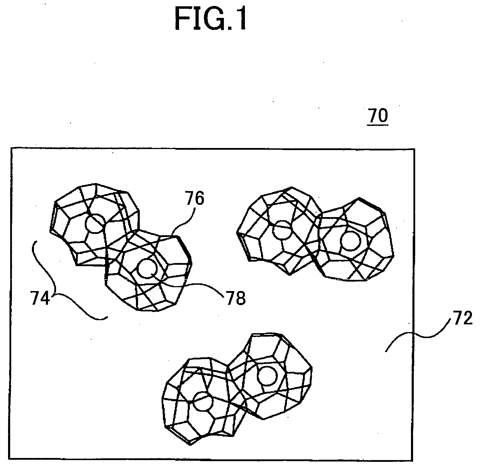

FIG. 1 is a schematic diagram showing a conceptual structure of an electride of an amorphous oxide including a calcium atom and an aluminum atom.

EMBODIMENTS FOR IMPLEMENTING THE INVENTION

In the present specification, "a thin film of an electride of an amorphous oxide including a calcium atom and an aluminum atom" may also be simply referred to as "an amorphous electride thin film."

A sputtering target according to the present invention is a sputtering target including an electrically conductive mayenite compound, wherein electron density of the electrically conductive mayenite compound is greater than or equal to $3\times10^{20}$ cm$^{-3}$, and wherein the electrically conductive mayenite compound includes one or more elements that are selected from a group including C, Fe, Na, and Zr.

In the present application, "a mayenite compound" is a general term of a chemical compound (isomorphic compound) of $12CaO\cdot7Al_2O_3$ (which is also referred to as "C12A7," hereinafter) having a cage structure and a chemical compound having a crystal structure that is the same as C12A7. There is $12SrO\cdot7Al_2O_3$, which is an isomorphic compound that is equivalent to C12A7.

In the present application, the "electrically conductive mayenite compound" may represent a mayenite compound such that a part of or all "free oxygen ions" included in cages are replaced with electrons. The electron density of the electrically conductive mayenite compound in the present invention can be greater than or equal to $3\times10^{20}$ cm$^{-3}$. It may preferably be greater than or equal to $5\times10^{20}$ cm$^{-3}$, it may more preferably be greater than or equal to $7\times10^{20}$ cm$^{-3}$, and it may further more preferably be greater than or equal to $1\times10^{21}$ cm$^{-3}$. Upon all the free oxygen ions being replaced with electrons, the electron density can be $2.3\times10^{21}$ cm$^{-3}$.

The electron density can be converted from a peak wavelength (energy) of a Kubelka-Munk converted absorption spectrum, which is obtained by measuring diffuse reflection from powder of the electrically conductive mayenite compound. The following formula is used as a relational expression:

$$n = (- (E_{sp} - 2.83) / 0.199)^{0.782}$$

Here, n indicates the electron density (cm$^{-3}$), and Esp indicates the peak energy (eV) of the Kubelka-Munk converted absorption spectrum.

A ratio between calcium (Ca) and aluminum (Al) in the electrically conductive mayenite compound can preferably be in a range from 10:9 to 13:6 in a molar ratio that is converted into CaO: $Al_2O_3$. It can more preferably be in a range from 11:8 to 12.5:6.5, it can more preferably be in a range from 11.5:7.5 to 12.3:6.7, it can further more preferably be in a range from 11.8:7.2 to 12.2:6.8, and it can particularly preferably be approximately 12:7.

In the sputtering target according to the present invention, a ratio of mass of carbon (C) with respect to mass of the target may preferably be greater than or equal to 0.0001% by mass and less than or equal to 5% by mass, and it is more preferably be greater than or equal to 0.001% by mass and less than or equal to 1% by mass.

In the sputtering target according to the present invention, an amount of each one of the elements Zr, Fe, and Na with respect to the mass of the target may preferably be greater than or equal to 0.0001% by mass and less than or equal to 1% by mass, and it may more preferably be greater or equal to 0.001% by mass and less than or equal to 0.1% by mass.

Within the ranges, a cage structure included in the mayenite compound that forms the sputtering target can be maintained. Additionally, it is possible to increase electric current density of an organic electroluminescence element that includes a thin film of the amorphous electride that is formed by using the sputtering target according to the present invention.

These elements can be quantified by using Inductively Coupled Plasma Mass Spectrometry (ICP-MS), Inductively Coupled Plasma Atomic Emission Spectrometry (ICP-AES), or a carbon component analysis method (thermal optical reflectance).

A method of producing the sputtering target according to the present invention is not particularly limited. The target may be produced by using a usual method of producing a bulk shaped electrically conductive mayenite compound, for example. For example, the target that is formed of the electrically conductive mayenite compound may be produced by applying, under presence of a reducing agent, such as Ti, Al, Ca, or C, a heating process of approximately from 1080 °C to 1460 °C, more preferably approximately from 1200 °C to 1400 °C, to a sintered body of a mayenite compound.

The one or more types of the elements that are included in the electrically conductive mayenite compound that forms the target according to the present invention and that are selected from the group that is formed of C, Fe, Na, and Zr may be intentionally added to a calcium compound, an aluminum compound, metal calcium, metal aluminum, and so forth that can be raw materials of the mayenite compound. The above-described elements may be mixed during a process of producing powder of the synthesized mayenite compound. Further, the above-described elements may be mixed during a process of producing a molded body from the powder of the mayenite compound. Further, the above-described elements may be mixed during a process of producing a sintered body from the molded body. Further, the above-described elements may be mixed during a reducing and heating process for synthesizing the electrically conductive mayenite compound. Each of the above-described elements may be added as a single substance or a chemical compound. A plurality of the elements may be added as a form of a composite compound and/or a form of an alloy.

A production method according to an embodiment of the present invention includes

(1) a process of preparing a to-be-processed body that includes a mayenite compound (process S110); and
(2) a process of disposing an aluminum foil at least on a part of a surface of the to-be-processed body, and maintaining the to-be-processed body at a temperature in a range from 1080 °C to 1450 °C under a low oxygen partial pressure environment (process S120).

Hereinafter, each process is explained.

(Process S110: Process of preparing a to-be-processed body)

A to-be-processed body including a mayenite compound is prepared. The to-be-processed body may be a molded body including the powder of the mayenite compound.

First, powder of raw materials for synthesizing the powder of the mayenite compound is mixed. The powder of the raw materials is mixed, so that a ratio between calcium (Ca) and aluminum (Al) is from 14:5 to 10:9 in the molar ratio in which they are converted into $CaO:Al_2O_3$. Especially, the ratio between calcium (Ca) and aluminum (Al) may preferably be from 13:6 to 11:8 in the molar ratio in which they are converted into $CaO:Al_2O_3$, it is more preferable that the ratio is from 12.6:6.4 to 11.7:7.3, and it is further more preferable that the ratio is from 12.3:6.7 to 11.8:7.2. Ideally, $CaO:Al_2O_3$ (molar ratio) may preferably be approximately 12:7. Note that chemical compounds that are used for the powder of the raw material are not particularly limited, provided that the above-described ratio can be maintained.

The powder of the raw materials may be mixed power including a calcium compound and an aluminum compound, for example. As a calcium compound, calcium carbonate, calcium oxide, calcium hydroxide, calcium hydrogencarbonate, calcium sulfate, calcium metaphosphate, calcium oxalate, calcium acetate, calcium nitrate, calcium halide, and so forth can be considered. Among these, calcium carbonate, calcium oxide, and calcium hydrogencarbonate may be preferable.

Sodium (Na) that is included in the electrically conductive mayenite compound that forms the target according to the present invention may be mixed as a foreign material in a calcium compound.

As an aluminum compound, aluminum hydroxide, aluminum oxide, aluminum sulfate, aluminum nitrate, aluminum halide, and so forth can be considered. Among these, aluminum hydroxide and aluminum oxide may be preferable. Types of aluminum oxide (alumina) may include α-alumina, γ-alumina, 5-alumina, and so forth. However, α-aluminum oxide (alumina) may especially preferable.

Iron (Fe) that is included in the electrically conductive mayenite compound that forms the target according to the present invention may be mixed as a foreign material in an aluminum compound.

Next, the mixed powder of the raw materials is maintained to be a high temperature, and a mayenite compound can be synthesized. The synthesis may be made under an inert gas atmosphere or under vacuum. However, the synthesis may preferable be made under the air atmosphere.

The temperature for the synthesis is not particularly limited. However, the temperature for the synthesis may be in a range from 1150 °C to 1460 °C, for example. The temperature may be maintained within this range, for example, from one hour to twelve hours.

The mayenite compound that is obtained by synthesis can be a bulk shape such that a part of or all of the mayenite compound is sintered. In order to obtain a mayenite compound having a desired shape or uniform electrical conductivity, the mayenite compound may preferably be broken to produce the powder of the mayenite compound.

A crushing process is applied to the bulk shaped mayenite compound by using a stamp mill or the like, until the size becomes approximately 5 mm, for example. Additionally, a crushing process is applied by using an automatic mortar or a dry ball mill, until an average particle diameter becomes approximately from 10 μm to 100 μm.

Further, when finer and uniform powder is desired to be obtained, for example, by using a wet ball mill or a circulation ball mill while using an alcohol (e.g., isopropyl alcohol) that can be represented by $C_nH_{2n+1}OH$ (n is an integer greater than or equal to three) as a solvent, the average particle diameter of the powder can be made finer in size until the size becomes from 0.5 μm to 50 μm.

Zirconium (Zr) that can be included in the electrically conductive mayenite compound that forms the target according to the present invention may be mixed from a container or a ball that can be used during crushing to produce the powder of the mayenite compound. A medium that is used for crushing may preferably be zirconia ($ZrO_2$) having a large specific gravity because powder having an average particle size of several microns can be obtained in a relatively short time period. Additionally, the container or the ball may be a complex oxide (e.g., a complex oxide having alumina and zirconia as main components).

Iron (Fe) that can be included in the electrically conductive mayenite compound that forms the target according to the present invention may be mixed from a jig or a tool formed of stainless steel that can be used in the process. For example, during production of the powder of the mayenite compound, it can be mixed from a mesh that is formed of stainless steel and that may be used for removing a large object that is not yet crushed after completing wet crushing.

Subsequently, a molded body is formed by using the obtained powder of the mayenite compound. A molding method of the molded body is not particularly limited. The molded body may be formed by various types of usual methods. For example, the molded body may be prepared by pressure-molding of a molding material that is formed of the powder of the mayenite compound or a kneaded mixture including the powder. A molded body may be obtained by press molding, sheet molding, extrusion molding, or injection molding of the molding material. The shape of the molded body is not particularly limited. For a case in which the molded body includes a binder that is formed of an organic compound, the molded body may preferably be heated in advance, and the binder may preferably be removed.

Carbon (C) that can be included in the electrically conductive mayenite compound that forms the target according to the present invention may be mixed as a residue of the binder.

For producing a sintered body including the mayenite compound by using the molded body including the obtained powder of the mayenite compound, the processing temperature is not particularly limited, provided that the molded body can be sintered under the condition. The molded body including the powder of the mayenite compound is sintered, for example, at a temperature range from 300 °C to 1450 °C, and thereby a sintered body including the mayenite compound can be formed. A time period of holding the maximum temperature of the heating process may be a range approximately from one hour to fifty hours.

The sintering process may be executed under the air atmosphere, an atmosphere of an inert gas, such as argon, helium, neon, and nitrogen, an oxygen gas, or mixture thereof, or under the vacuum.

The obtained sintered body including the mayenite compound may be processed to have a desired shape, depending on necessity. The processing method is not particularly limited. Mechanical processing, electrical discharge processing, laser processing and so forth may be applied.

Carbon (C) and iron (Fe) that can be included in the electrically conductive mayenite compound that forms the target according to the present invention may be mixed as a member and/or a polishing agent during processing.

(Process S120: Heat treatment process of the to-be-processed body)

Subsequently, a high-temperature process is applied to the to-be-processed body under a low oxygen partial pressure atmosphere. By doing this, sintering of the particles of the mayenite compound included in the to-be-processed body is progressed, and at the same time, oxygen ions in the cages of the mayenite compound are replaced with electrons. In this manner, the electrically conductive mayenite compound can be formed.

In the producing method according to the embodiment of the present invention, an aluminum foil may be disposed on at least a part of the surface of the to-be-processed body. Upon disposing the aluminum foil on the surface of the to-be-processed body, the aluminum foil may or may not contact the surface of the to-be-processed body. However, when the temperature of the to-be-processed body is maintained to be in a range from 1080 °C to 1450 °C, it may be required to dispose the aluminum foil so that a molten material that is derived from the aluminum foil is in a state in which the molten material contacts the surface.

Next, high temperature processing is applied to the to-be-processed body under the low oxygen partial pressure atmosphere. Here, the aluminum foil is disposed on at least the part of the surface of the to-be-processed body. The low oxygen partial pressure in the atmosphere may preferably be less than or equal to $1 \times 10^{-3}$ Pa, it may more preferably be less than or equal to $1 \times 10^{-5}$ Pa, it may further more preferably be less than or equal to $1 \times 10^{-10}$ Pa, and it may particularly preferably be less than or equal to $10 \times 10^{-18}$ Pa. The atmosphere may be an inert gas atmosphere, or a reduced pressure atmosphere (e.g., a vacuum atmosphere in which the pressure is less than or equal to 100 Pa).

The low oxygen partial pressure atmosphere may include a carbon monoxide gas. The carbon monoxide gas may be supplied from outside the environment where the to-be-processed body is disposed. However, the to-be-processed body may be disposed in a container including carbon, and the carbon monoxide gas may be supplied from the side of the container. As a container, for example, a container formed of carbon may be used, and a sheet formed of carbon and/or a plate formed of carbon may be disposed in the environment.

The temperature of the heat treatment processing may preferably be in a range from 1080 °C to 1450 °C. A time period for holding the to-be-processed body at a high temperature may preferably be in a range from thirty minutes to fifty hours.

The sputtering target according to the present invention can be produced by the processes above.

A thickness of the sputtering target according to the present invention may preferably be from 2.0 mm to 15.0 mm, it may more preferably be from 2.5 mm to 13.0 mm, it may further more preferably be from 3.0 mm to 10.0 mm, and it may particularly preferably be from 3.0 mm to 8.0 mm.

In a disk-shaped flat target, it's diameter may preferably be greater than or equal to 50 mm, it may more preferably be greater than or equal to 75 mm, it may further more preferably be greater than or equal to 100 mm, and it may particularly preferably be greater than or equal to 200 mm. In a rectangular flat target, a size of it's long side may preferably be greater than or equal to 50 mm, it may more preferably be greater than or equal to 75 mm, it may further more preferably be greater than or equal to 100 mm, and it may particularly preferably be greater than or equal to 200 mm. In a cylindrical target, a height of it's cylinder may preferably be greater than or equal to 50 mm, it may preferably be greater than or equal to 75 mm, it may more preferably be greater than or equal to 100 mm, and it may particularly preferably be greater than or equal to 200 mm.

In the sputtering target according to the present invention, it is desirable that the relative density is greater, it may preferably be greater than or equal to 90%, it may more preferably be greater than or equal to 93%, and it may particularly preferably be greater than or equal to 95%.

By forming a film on a substrate by the sputtering method under a low oxygen partial pressure atmosphere while using the sputtering target according to the present invention, a thin film of an electride of an amorphous oxide including a calcium atom and an aluminum atom can be formed.

The temperature of the substrate on which the film is to be formed during formation of the thin film of the amorphous electride is not particularly limited, and any temperature in a range from ambient temperature to 700 °C, for example, may be adopted. Note that, during formation of the thin film of the electride, it may not be necessary to "actively" heat the substrate. However, due to radiation heat of an evaporation source, it is possible that the temperature of the substrate on which the film is to be formed may be "subordinately" risen. For example, the temperature of the substrate on which the film is to be formed may be less than or equal to 500 °C, and it may be less than or equal to 200 °C. In case where the substrate is not "actively" heated, it may become possible to use, as a material of the substrate, a material such that the heat resistance of the material is lowered at a side of a high temperature that exceeds 700 °C, such as glass and plastic.

Oxygen partial pressure during formation of the film may preferably be less than 0.1 Pa. The oxygen partial pressure may preferably be less than or equal to 0.01 Pa, it may more preferably be less than or equal to $1 \times 10^{-3}$ Pa, it may further more preferably be less than or equal to $1 \times 10^{-4}$ Pa, and it may particularly preferably be less than or equal to $1 \times 10^{-5}$ Pa. If the oxygen partial pressure becomes greater than or equal to 0.1 Pa, oxygen may be incorporated into the formed thin film, and the electron density may be lowered.

The sputtering gas that is to be used is not particularly limited, and it may be an inert gas or a noble gas. As an inert gas, $N_2$ gas may be considered, for example. Further, as a noble gas, helium (He), neon (Ne), argon (Ar), krypton (Kr), or xenon (Xe) may be considered. These may be used alone, or may be used in combination with other gases. Alternatively, the sputtering gas may be a reducing gas, such as nitric monoxide (NO).

The pressure of the chamber is not particularly limited, and it may be freely selected so that a desired thin film can be obtained. Specifically, if the distance between the substrate and the target is t (m) and the diameter of the molecule of the gas is d (m), the pressure P (Pa) of the chamber may be selected so that the following formula is satisfied:

$$8.9 \times 10^{-22}/(td^2) < P < 4.5 \times 10^{-20}/(td^2) \quad \text{Formula (3).}$$

In this case, a mean free path of a sputtered particle may become almost equal to a distance between the target and the substrate on which the film is to be formed, so that the sputtered particle may be suppressed from being reacted with residual oxygen. Further, in this case, as a device for the sputtering method, a less expensive and simple vacuum apparatus can be used such that the back pressure is relatively high.

By such a method, a thin film of an electride of an amorphous oxide including a calcium atom and an aluminum atom can be formed.

In the present application, "an electride of an amorphous oxide including a calcium atom and an aluminum atom" may mean an amorphous solid material formed of a solvation such that an amorphous including a calcium atom, an aluminum atom, and an oxygen atom is a solvent, and electrons are a solute. Electrons in the amorphous oxide can function as anions. Electrons may exist as bipolarons.

FIG. 1 conceptually shows a structure of an electride of an amorphous oxide. As shown in FIG. 1, the electride 70 of the amorphous oxide may exist in a state in which characteristic partial structures, which are called bipolarons 74, are dispersed in a solvent 72 that is formed of an amorphous material including a calcium atom, an aluminum atom, and an oxygen atom. The bipolaron 74 is formed in such a way that two cages 76 are adjacent, and further each cage 76 includes an electron (a solute) 78. Further, the state may be such that a plurality of the cages is condensed. The condensed cages can be deemed as a fine crystal. Thus, a state in which fine particles are included in an amorphous material can also be deemed as an amorphous state.

The bipolaron may absorb almost no light in a range of visible light in which photon energy is from 1.55 eV to 3.10 eV, and the bipolaron exhibits an optical absorption property in the vicinity of 4.6 eV. Thus, an amorphous electride thin film is transparent under visible light. Further, by measuring an optical absorption property of a sample of a thin film, and measuring an optical-absorption coefficient in the vicinity of 4.6 eV, it can be confirmed whether a bipolaron exists in the sample of the thin film, namely, whether the sample of the thin film includes an electride of an amorphous oxide. An optical absorption value at a position of 4.6 eV may be greater than or equal to 100 $cm^{-1}$, and it can be greater than or equal to 200 $cm^{-1}$.

The molar ratio between aluminum atoms and calcium atoms (Ca/Al) in the amorphous electride thin film may preferable be in a range from 0.3 to 5.0. If it is greater than or equal to 0.3, the high electron density can be maintained. Additionally, if it is less than or equal to 5.0, the durability of the thin film can be superior. It may more preferably be in a range from 0.5 to 1.6, and it may particularly preferably be in a range from 0.6 to 1.2. A composition analysis of the thin film may be performed by an XPS method, an EPMA method, or an EDX method, for example. If the thickness of the film is less than or equal to 100 nm, an analysis can be performed by the XPS method, if it is greater than or equal to 50 nm, an analysis can be performed by the EPMA method, and if it is greater than or equal to 3 $\mu$m, an analysis can be performed by the EDX method.

The composition of the amorphous electride thin film may be different from a stoichiometric ratio of C12A7, and the composition of the amorphous electride thin film may be different from a composition ratio of the electrically conductive mayenite compound that is included in the target that is used for the production. For a case of a crystalline material, if it's composition is different from the stoichiometric ratio of C12A7, it becomes a mixture of a crystal of C12A7, a crystal of C3A ($3CaO \cdot Al_2O_3$), and/or a crystal of CA ($3CaO \cdot Al_2O_3$). Depending on a portion of a crystal, an electric property may become uneven because the crystal of C3A and the crystal of CA are insulators, and their work functions are large. Additionally, a discontinuous grain boundary tends to be formed and flatness of the surface may be low because thermal and mechanical properties of these crystals are different. Whereas, for an amorphous thin film, even if it's composition is different from a stoichiometric ratio of C12A7, different phases, such as the crystal of C3A and the crystal of CA, may not be formed. Thus, the amorphous thin film can be uniform, and the flatness of the surface can be high.

The amorphous electride thin film may preferably include electrons such that the electron density is in a range that is greater than or equal to $2.0 \times 10^{17}$ $cm^{-3}$ and less than or equal to $2.3 \times 10^{21}$ $cm^{-3}$. The electron density may preferably be greater than or equal to $1 \times 10^{18}$ $cm^{-3}$, it may more preferably be greater than or equal to $1 \times 10^{19}$ $cm^{-3}$, and it may particularly preferably be greater than or equal to $1 \times 10^{20}$ $cm^{-3}$.

Note that the electron density of the amorphous electride thin film can be measured by an iodometric titration flow method. The iodometric titration flow method is such that a sample formed of the electride is immersed in a solution of iodine of 5 mol/l, and after it is dissolved by adding hydrochloric acid, an amount of unreacted iodine that is included in the solution is detected by titration by using sodium thiosulfate. In this case, by dissolution of the sample, iodine in the iodine solution can be ionized by the following reaction:

$$I_2 + 2\ e^- \rightarrow 2I^- \qquad \text{Formula (1).}$$

Further, if the iodine solution is titrated by sodium thiosulfate, the unreacted iodine is changed into sodium iodide by the following reaction:

$$2Na_2S_2O_3 + I_2 \rightarrow 2NaI + Na_2S_4O_6 \qquad \text{Formula (2).}$$

By subtracting an amount of iodine that is detected by the titration of the formula (2) from the amount of iodine that exists in the original solution, an amount of iodine that is consumed by the reaction of the formula (1) can be calculated. In this manner, the electron density in the sample of the electride can be measured.

The amorphous electride thin film exhibits an electric property that is similar to that of a semiconductor, and the amorphous electride thin film has a low work function. The work function can be from 2.4 eV to 4.5 eV, and it can be 2.8 eV to 3.2 eV. Further, the amorphous electride thin film has a large ionization potential. The ionization potential may be from 7.0 eV to 9.0 eV, and it can be from 7.5 eV to 8.5 eV. The amorphous electride thin film can be highly transparent because the amorphous electride thin film has a $F^+$ center of less than $5 \times 10^{18} cm^{-3}$. The density of the $F^+$ center may more preferably be less than or equal to $1 \times 10^{18}$ $cm^3$, and it can be further more preferably be less than or equal to $1 \times 10^{17}$ $cm^{-3}$. In the amorphous electride thin film, a ratio of an optical absorption coefficient at a position of the photon energy of 4.6 eV with respect to an optical absorption coefficient at a position of 3.3 eV may be less than or equal to 0.35.

The film thickness of the amorphous electride thin film may be less than or equal to 100 nm, for example, it may preferably be less than or equal to 10 nm, and it may more preferably be less than or equal to 5 nm. It may be greater than or equal to 0.5 nm.

The amorphous electride thin film can have electric conductivity due to hopping conduction of the electrons in the cages. The direct current electrical conductivity of the thin film of the electride in an ambient temperature may be from $10^{-11}$ to $10^{-1}$ $S \cdot cm^{-1}$, and it may be from $10^{-7}$ to $10^{-3}$ $S \cdot cm^{-1}$.

The amorphous electride thin film is superior in flatness. A root mean square roughness (RMS) of the surface of the thin film of the electride according to the present invention may be from 0.1 nm to 10 nm, and it may be from 0.2 nm to 5 nm. The RMS may more preferably be less than or equal to 2 nm because the characteristic of the element can be enhanced. Further, if the RMS is greater than or equal to 10 nm, the characteristic of the element may be lowered. Thus, it may be necessary to add a polishing process. The above-described RMS may be measured by using an atomic force microscope, for example.

The direct current electrical conductivity of the electride of the amorphous oxide may be approximately $10^{-6}$ S/cm, while the direct current electrical conductivity of the electrically conductive mayenite compound, which is a crystalline material, may be approximately 1500 S/cm. Thus, by crystalizing the amorphous electride thin film by low temperature thermal processing, it is considered that the direct current electrical conductivity can be increased.

At this time, it is preferable that the entire film is not crystalized. That is because, though the amorphous electride thin film is homogeneous, the amorphous electride thin film may become inhomogeneous by crystallization, and a defect may occur in a part of an element that uses the thin film. In this manner, in order to maintain the homogeneity of the film, it may be necessary to crystalize the film in such a manner that the homogeneity of the film can be maintained, for example, by crystallizing a part of the thin film of the amorphous electride, by separating a fine crystal in the order of several nanometers to several micrometers, or by separating a deformed crystal.

INDUSTRIAL APPLICABILITY

The thin film that can be obtained by using the sputtering target according to the present invention can be applied to a method of producing an electrode layer and an electron injection layer of an organic electroluminescence element, a method of producing a discharging electrode, and a method of producing a catalyst for chemical synthesis, for example.

The present application is based on and claims the benefit of priority of Japanese Priority Application No. 2013-134006 filed on June 26, 2013 and Japanese Priority Application No. 2013-265587 filed on December 24, 2013, the entire contents of the Japanese Priority Applications are hereby incorporated herein by reference.

DESCRIPTION OF THE REFERENCE NUMERALS

70　Electride of amorphous oxide
72　Solvent (amorphous)
74　Bipolaron
76　Cage
78　Electron (solute)

**Claims**

1. A sputtering target for forming an amorphous film, the sputtering target including an electrically conductive mayenite compound,
   wherein electron density of the electrically conductive mayenite compound is greater than or equal to $3 \times 10^{20}$ cm$^{-3}$, and
   wherein the electrically conductive mayenite compound includes one or more elements that are selected from a group including C, Fe, Na, and Zr.

2. The sputtering target according to claim 1,
   wherein the electrically conductive mayenite compound includes the one or more elements that are selected from a group including C, Fe, and Zr.

3. The sputtering target according to claim 1,
   wherein the electrically conductive mayenite compound includes Na.

4. The sputtering target according to any one of claims 1 to 3,
   wherein the sputtering target is any one of a disk-shaped flat target having a diameter of greater than or equal to 50 mm, a rectangular flat target such that a size of a long side is greater than or equal to 50 mm, and a cylindrical target such that a height of a cylinder is greater than or equal to 50 mm.

**5.** A method of producing a thin film of an electride of an amorphous oxide including a calcium atom and an aluminum atom,

wherein the thin film of the electride of the amorphous oxide including the calcium atom and the aluminum atom is formed on a substrate by a sputtering method while using the sputtering target according to any one of claims 1 to 4 under a low oxygen partial pressure atmosphere.

# FIG.1

## INTERNATIONAL SEARCH REPORT

| International application No. |
| --- |
| PCT/JP2014/064593 |

A.　CLASSIFICATION OF SUBJECT MATTER
*C23C14/34*(2006.01)i, *C04B35/44*(2006.01)i

According to International Patent Classification (IPC) or to both national classification and IPC

B.　FIELDS SEARCHED

Minimum documentation searched (classification system followed by classification symbols)
C23C14/34, C04B35/44

Documentation searched other than minimum documentation to the extent that such documents are included in the fields searched
Jitsuyo Shinan Koho　　　　1922–1996　Jitsuyo Shinan Toroku Koho　1996–2014
Kokai Jitsuyo Shinan Koho　1971–2014　Toroku Jitsuyo Shinan Koho　1994–2014

Electronic data base consulted during the international search (name of data base and, where practicable, search terms used)

C.　DOCUMENTS CONSIDERED TO BE RELEVANT

| Category* | Citation of document, with indication, where appropriate, of the relevant passages | Relevant to claim No. |
| --- | --- | --- |
| Y | JP 2008-195583 A　(Japan Science and Technology Agency), 28 August 2008 (28.08.2008), paragraphs [0017] to [0050] (Family: none) | 1-5 |
| Y | JP 2008-47434 A　(Asahi Glass Co., Ltd.), 28 February 2008 (28.02.2008), paragraphs [0010] to [0064] (Family: none) | 1,2,4,5 |
| Y | JP 2012-46365 A　(Krosaki Harima Corp.), 08 March 2012 (08.03.2012), paragraph [0020] (Family: none) | 1,3 |

| ☒ | Further documents are listed in the continuation of Box C. | ☐ | See patent family annex. |

| * | Special categories of cited documents: | "T" | later document published after the international filing date or priority date and not in conflict with the application but cited to understand the principle or theory underlying the invention |
| "A" | document defining the general state of the art which is not considered　to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 11 August, 2014 (11.08.14) | 26 August, 2014 (26.08.14) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

International application No.

PCT/JP2014/064593

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2002-146346 A (Minolta Co., Ltd.), 22 May 2002 (22.05.2002), paragraphs [0057] to [0081] & US 2002/0086190 A1 | 4 |
| A | C.Jung and D.H.Yoon, Characterisation of 12CaO. 7Al2O3 insulator and electride doped indium tin oxide thin films for OLED applications, Surface Engineering, 2011.08.19 (received date), Vol.27,No.5, pp.389-392 | 1-5 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005000741 A
- JP 2013134006 A

- JP 2013265587 A

**Non-patent literature cited in the description**

- **F. M. LEA ; C. H. DESCH.** The Chemistry of Cement and Concrete. Edward Arnold & Co, 1956, 52